**Europäisches Patentamt**

**European Patent Office**

**Office européen des brevets**

(11) Veröffentlichungsnummer: **0 478 919 A2**

# EUROPÄISCHE PATENTANMELDUNG

(21) Anmeldenummer: **91112657.1**

(22) Anmeldetag: **27.07.91**

(51) Int. Cl.5: **H03M 1/12**

(30) Priorität: **01.10.90 DE 4030988**

(43) Veröffentlichungstag der Anmeldung:
**08.04.92 Patentblatt 92/15**

(84) Benannte Vertragsstaaten:
**DE FR GB**

(71) Anmelder: **DORNIER GMBH**
**Postfach 1420**
**W-7990 Friedrichshafen 1(DE)**

(72) Erfinder: **Kratz, Harald,Dipl.-Ing.**
**Untere Holunderstaffel 15**
**W-7992 Tettnang(DE)**
Erfinder: **Ludwig, Wolfgang,Dr.**
**Seeblickstrasse 18**
**CH-8274 Trägerwilen(CH)**

(74) Vertreter: **Kasseckert, Rainer**
**DORNIER GMBH Kleeweg 3**
**W-7990 Friedrichshafen 1(DE)**

(54) **Supraleitender A/D-Wandler.**

(57) Supraleitender Analog/Digital-Wandler, bei dem mindestens eine der elektrischen Zu- oder Ableitungen von einer optischen Zuleitung (Lichtleiter **F1**, **F2**, **F3**, **F4**) ersetzt ist, wobei die Stromsignale durch opto-elektronische und/oder magneto-optische Elemente erzeugt oder umgesetzt werden.

Fig.

Rank Xerox (UK) Business Services

Die Erfindung betrifft einen supraleitenden A/D-Wandler nach dem Oberbegriff des Anspruchs 1.

Supraleitende A/D-Wandler sind aus mehreren Veröffentlichungen bekannt, z.B. aus den deutschen Patentschriften **33 10 245, 37 38 369 oder 36 39 623.** Bei all diesen Vorrichtungen ist es nötig, dem Wandler Gleichströme oder elektrische Pulse zuzuführen. Dies erfolgt in der Regel über metallische Leitungen. Da die Wandler bei tiefen Temperaturen betrieben werden (in Kryostaten) wirken die elektrischen Leitungen auch als Wärmeleitungen und führen zu Wärmeverlusten. Bei Systemen mit vielen gleichzeitig betriebenen A/D-Wandlern kommt noch hinzu, daß zwischen den einzelnen Leitungen elektrische Kopplungen auftreten können, die zu Leistungseinbußen der einzelnen Wandler führen.

Aufgabe der Erfindung ist es, einen supraleitenden A/D-Wandler vorzuschlagen, der innerhalb eines Systems vieler gleichzeitig betriebener A/D-Wandler sicher im supraleitenden Zustand arbeitet, insbesondere darf er die Supraleitfähigkeit nicht verlieren.

Diese Aufgabe wird erfindungsgemäß gelöst von einem Wandler mit den Merkmalen des Anspruchs 1. Ausführungen der Erfindung sind Gegenstände von Unteransprüchen.

Durch den erfindungsgemäßen Einsatz von optischen Leitern (Lichtleitern), die normalerweise aus Glas bestehen und nur eine sehr geringe Wärmeleitfähigkeit haben, wird einerseits die Kopplung zwischen den Leitungen vermieden, auf der anderen Seite sind die thermischen Verluste auch bei einem Vielkanalsystem nur sehr gering.

Eine Ausführung der Erfindung wird anhand einer Figur näher erläutert.

Diese Fig. zeigt ein Prinzipschaltbild eines erfindungsgemäßen A/D-Wandlers, der hier die SQUID's **SQ1**, **SQ2** die Ein- und Auskoppelspulen **S1**, **S2** sowie die zu versorgenden folgenden Ein- und Ausgänge enthält:

**E1**: Gleichströme zur Einstellung der Arbeitspunkte

**E2**: Pulse zum Abtasten der Eingangssignale der SQUID-Komparatoren

**E3**: Rückkopplungsleitungen

**A1**: Pulsausgang zur Information über den Schaltzustand der SQUID-Komparatoren.

An diese Ein- und Ausgänge sind hier erfindungsgemäß optische Lichtleiter (Fasern **F1**, **F2**, **F3**, **F4**) angeschlossen. Die Eingänge **E1** und **E2** werden hier direkt über opto-elektronische Umwandlung eines Lichtpulses in einen Stromimpuls bedient. Dazu dienen die Photodioden (z.B. aus Gallium-Arsenit) an den Faserenden der Fasern **F1** und **F2**.

Der Eingang **E3** kann hier aus Stabilitätsgründen und wegen der notwendigen Bipolarität nicht direkt umgewandelt werden. Vielmehr wird ein frequenzmoduliertes optisches Signal opto-elektronisch in ein Stromsignal umgewandelt, welches nach der Demodulation im Demodulator **D** den Eingang **E3** versorgt.

Der Ausgang **A1** liefert einen Stromimpuls im mA-Bereich. Zu dessen Umwandlung in einen Lichtpuls für die Faser **F4** ist hier eine magneto-optische Schicht **S** vorgesehen. Der Strompuls erzeugt über eine geeignete Spule ein Magnetfeld, welches den Polarisationswinkel bei Reflexion an einer magneto-optischen Schicht aus einer $EuS/EuF_2$-Mischung verändert. Dadurch läßt sich das Signal mit Hilfe von polarisiertem Licht auslesen.

Mit Hilfe handelsüblicher optischer Fasern, wie z.B. Multimode-, Monomode- oder Gradientenfasern, lassen sich erfindungsgemäß alle notwendigen Aus- und Eingänge der supraleitenden A/D-Wandler versorgen.

Die Erfindung ist auch bei anders aufgebauten supraleitenden A/D-Wandlern anwendbar. Je nach Einsatz und Anforderungen können einer oder mehrere der Ein- und Ausgänge durch optische Fasern ersetzt sein. Auch können über Frequenzmultiplexer mehrere Ein- oder Ausgänge durch eine einzige Faser versorgt werden.

Erfindungsgemäße supraleitende A/D-Wandler eignen sich vor allem im Bereich der Medizintechnik zur biomagnetischen Diagnostik von Gehirn und Herzkrankheiten. In diesem Bereich werden Systeme mit besonders hohen Kanalzahlen (> 100) verlangt.

Im militärischen Bereich finden solche A/D-Wandler ihren Einsatz, vor allem bei der Ortung von U-Booten und Minen. Im Bereich der Hochfrequenztechnik sind sie als Ausleseschaltungen für Spektrumsanalysatoren und Phasenschieber bekannt.

Weitere Anwendungen liegen im Bereich der Geoprospektion, Gravitationsmessung und allgemeinen Meßtechnik.

Mit den erfindungsgemäßen Vorrichtungen werden primär Magnetfelder oder Ströme gemessen. Die Meßgrößen sind jedoch sehr unterschiedlich:

- Geoprospektion:
Magnetfelder, Magnetfeldgradienten
- Gravitationsmessung:
Beschleunigung, Beschleunigungsgradienten
- Meßtechnik:
Magnetfelder, Ströme, Spannungen usw.

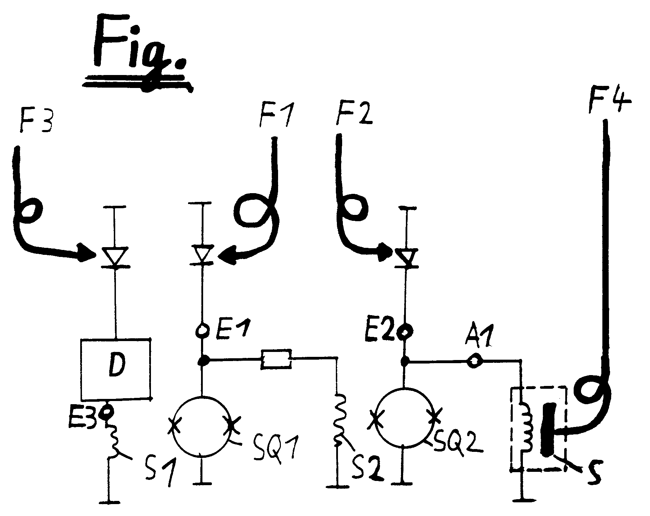

**Patentansprüche**

1. Supraleitender Analog/Digital-Wandler, **durch gekennzeichnet,** daß mindestens eine der elektrischen Zu- oder Ableitungen von einer optischen Zuleitung (Lichtleiter **F1, F2, F3, F4**) ersetzt ist, wobei die Stromsignale durch opto-elektronische (Dioden) und/oder magneto-optische Elemente (magneto-optische Schicht **S**) erzeugt oder umgesetzt werden.

2. A/D-Wandler nach Anspruch 1, **dadurch gekennzeichnet**, daß alle Zuleitungen Lichtleiter (**F1 bis F4**) sind.

3. A/D-Wandler nach Anspruch 1 oder Anspruch 2, **dadurch gekennzeichnet**, daß integriert-optische Elemente, wie z.B. optische Multiplexer und optische Koppler, vorgesehen sind.

Fig.